(19) Europäisches Patentamt
European Patent Office
Office européen des brevets

(11) **EP 4 403 605 A1**

(12) **EUROPEAN PATENT APPLICATION**
published in accordance with Art. 153(4) EPC

(43) Date of publication:
**24.07.2024 Bulletin 2024/30**

(21) Application number: **22869310.7**

(22) Date of filing: **15.09.2022**

(51) International Patent Classification (IPC):
*C08L 77/06* (2006.01)    *C08K 3/34* (2006.01)
*C08K 3/04* (2006.01)    *G09F 9/33* (2006.01)
*G02B 1/04* (2006.01)

(52) Cooperative Patent Classification (CPC):
**C08K 3/04; C08K 3/34; C08L 77/06; G02B 1/04;
G09F 9/33**

(86) International application number:
**PCT/CN2022/118968**

(87) International publication number:
**WO 2023/040942 (23.03.2023 Gazette 2023/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **18.09.2021 CN 202111098360**

(71) Applicants:
• **ZHUHAI VANTEQUE SPECIALTY ENGINEERING
PLASTICS CO., LTD.**
**Guangdong 519050 (CN)**
• **KINGFA SCI. & TECH. CO., LTD.**
**Guangzhou, Guangdong 510663 (CN)**

(72) Inventors:
• **YANG, Huixin**
**Zhuhai, Guangdong 519050 (CN)**

• **HUANG, Xianbo**
**Zhuhai, Guangdong 519050 (CN)**
• **MAI, Jiehong**
**Zhuhai, Guangdong 519050 (CN)**
• **JIANG, Sujun**
**Zhuhai, Guangdong 519050 (CN)**
• **JIANG, Zhiqiang**
**Zhuhai, Guangdong 519050 (CN)**
• **YAN, Kun**
**Zhuhai, Guangdong 519050 (CN)**
• **LI, Jianwei**
**Zhuhai, Guangdong 519050 (CN)**
• **XU, Xianjun**
**Zhuhai, Guangdong 519050 (CN)**

(74) Representative: **Canzler & Bergmeier
Patentanwälte
Partnerschaft mbB
Despag-Straße 6
85055 Ingolstadt (DE)**

(54) **PA10T MOLDING COMPOSITE MATERIAL, AND PREPARATION METHOD THEREFOR AND
APPLICATION THEREOF**

(57)    The present invention provides a PA10T molding composite material that can be used to produce LED display light source reflection supports. The width of the crystallization peak at half height $\Delta T1/2$ is adjusted to 3°C-10°C, the whiteness is adjusted to be less than 26, and the 460 nm light source reflectivity is adjusted to be less than 6.5%, such that the PA10T molding compound has the advantages of low blue light, high contrast, and high grayscale, can satisfy requirements of a packaging process and long-term reliability, and can be used as a packaging product to manufacture high-contrast LED display light source reflection supports applicable in multiple scenarios.

EP 4 403 605 A1

**Description**

## TECHNICAL FIELD

The present invention relates to the technical field of high polymer materials, and in particular, to a PA10T molding composite material, a preparation method therefor and use thereof.

## BACKGROUND

LED light source mainly consists of a semiconductor chip, an LED light source reflection support, gold wire, and a packaging adhesive. The LED light source reflection support is the "framework" of an LED light source, and also is a functional element. LED packaging process is to assemble other materials and components therein through die bonding, wire welding, and packaging adhesive solidification. The LED reflection support needs to reflect the light emitted from an LED chip through a certain angle to reduce light loss, and to enable the light to transmit through packaging materials such as an epoxy resin or a silica gel, thus forming LED illumination or a light source displayed. The LED reflection support material is a kind of core LED lighting material and directly concerns the performance and service life of the LED light source.

The several points need to be considered in the selection of the LED reflection support material at the present stage:

Firstly, in the whole packaging process, the LED reflection support needs to be exposed at 150-200°C for 6-10 h; meanwhile, the packaged lamp beads need to be treated with a surface mount technology (SMT) when prepared to a display; the LED support or lamp bead is required to be free of deformation and free of damage under a load during the packaging or SMT process. Moreover, there is a higher demand for the tightness of the LED support material.

Secondly, in recent years, the LED display light source has gradually developed into a small-pitch display having a dot pitch of P2.5 below such that research & development and manufacturing of the LED display are unremittingly experiencing a great challenge. The small-pitch display support is gradually developed into thin wall, multi-mold cavity, and small size, which is more demanding for the mobility of the LED reflection support material, formability of the excessive mold cavities, mechanical strength, and the like.

Thirdly, during use procedure, the LED luminaire or display is often affected by severe weather such as high temperature, typhoon, rainstorm, thunder and lightning under different environment. To ensure the luminaire or display safe and sound in severe weather, there is a higher demand for the dimensional stability of the materials used, and other performances.

Fourthly, in the field of LED display application, to ensure the display image clear and keen, the display brightness and contrast are very important indicators. Currently, the solution used on the market more is the LED support produced by the pure white LED reflection support material; the support surface needs to be silk-screen printed with black ink; the process is tedious, efficiency is affected and cost is high; however, the surfaces of its side and reflection cup are still white, which reduces the contrast and gray scale displayed by the LED display.

Fifth, in terms of light source: on one hand, the wavelength capable of being perceived by ordinary people's eyes ranges from 780 nm to 400 nm. Short-wave blue ray having a wavelength of 400-450 nm causes the most serious extent of harm to retina; the blue ray at such a wavelength will increase the amount of toxins in the macular region of eyes, thereby seriously threatening people's eyes health. On the other hand, the light source of the LED full-color display consists of red (R), green (G), and blue (B) three chips, of which the brightness of the blue ray chip is the lowest, i.e., the contrast is the highest. Therefore, the overall contrast of the LED display will be directly affected by the reflectivity of chip-based blue ray on the LED light source support. LED screen anti blue-ray has popularized to the LED screens of various mobile phones and TVs; ordinary means are to paint an anti-blue ray film on the surface of the screen, but the means has the shortcomings of weak film and high costs, respectively.

Those skilled in the art are mainly focused on the aforesaid first and second points in terms of the improvement of the LED reflection support material. Packaging stability of the polyamide molding composite material is concerned less. Moreover, the contrast and gray scale of the LED display support are not improved by improving the contrast and gray scale of the material per se.

## SUMMARY

The objective of the present invention is to overcome the technical shortcomings, and to provide a polyamide molding composite material; the present invention has a high contrast and a high gray scale and thus, can satisfy requirements for a packaging process and long-term reliability.

Another objective of the present invention is to provide use of the aforesaid polyamide molding composite material.

The present invention is achieved by the following technical solution:

A PA10T molding composite material includes the following components in parts by weight:

| | |
|---|---|
| PA10T resin | 40-70 parts; |
| wollastonite | 30-60 parts; and |
| toner | 0.4-5 parts; |

in a resin matrix of the PA10T molding composite material, the wollastonite has an average diameter of 4-20 $\mu$m and an average length of 10-250 $\mu$m;

a crystallization peak width at half maximum $\Delta T_{1/2}$ of the PA10T molding composite material is measured to be 3-10°C by differential scanning calorimetry at a cooling rate of 20°C/min after being heated up to 345°C;

and where the PA10T molding composite material has a whiteness of less than 26 and a 460 nm light source reflectivity of less than 6.5%.

Preferably, a crystallization peak width at half maximum $\Delta T_{1/2}$ of the PA10T molding composite material is measured to be 4.5-7°C by differential scanning calorimetry at a cooling rate of 20°C/min after being heated up to 345°C.

The PA10T resin in the present invention may be a commercially available product, and also may be synthesized by the following method. To achieve more precise experiment, the PA10T used in the examples and comparative examples of the present invention is a homemade sample; raw materials such as monomers and end-capping reagents are commercially available products.

(1) Pre-polymerization: terephthalic acid, 1,10-diaminodecane, an end-capping reagent benzoic acid and deionized water are added to a stainless steel high-pressure reactor provided with mechanical stirring. The reactor is vacuumized and replaced with $N_2$ for three times, heated up to 180°C at a heating rate of 5°C/min and stirred, 60 min later after constant temperature, heated up to 270°C at a heating rate of 2°C/min, slowly stirred and subjected to constant temperature for 4 h such that the pre-polymerization reaction is performed fully. After the constant temperature, the reactor was slowly heated up to 280°C, and water is drained off to get normal pressure. The drain valve is turned off after the pressure reduces to normal pressure, after the reaction, the rector is cooled to room temperature, and discharged.

(2) Solid phase viscosification: the materials prepared during the pre-polymerization are added to a vacuum rotary blower with a rotational speed preset at 10 r/min and a vacuum degree preset at 30 Pa. The rotary blower is heated up to 265°C at a rate of 20°C/min, samples are then taken and tested to obtain a viscosity, and the discharging end point is determined according to the viscosity (or number average molecular weight).

The range of the number average molecular weight of the PA10T is not particularly defined in the present invention; the number average molecular weight of the PA10T resin is 1,500-26,000, which may achieve the objectives of the present invention. The number average molecular weight is tested by a conventional method, specifically as follows: the number average molecular weight (Mn) of the PA10T resin sample is determined by gel permeation chromatography (GPC). Agilent HPLC- 1260 high performance liquid chromatograph, preparation: Eppendorf column oven, Shodex KF-801, 802, 802.5 and 803 GPC columns, differential detector, and G7129A automatic sampler. The molecular weight of the resin is determined at a column temperature of 40°C using hexafluoroisopropanol as a mobile phase. Data is processed using the cirrus software of a chromatographic work station to obtain the number average molecular weight distribution Mn.

Preferably, in the resin matrix of the PA10T molding composite material, the wollastonite has an average diameter of 6-13 $\mu$m and an average length of 80-120 $\mu$m; Wollastonite is a kind of powder having a certain length-to-diameter ratio, its microstructure is fibrous, and its length and diameter almost keep the same during the shear melting process of a screw. Experiments show that two substances, PA10T and wollastonite (average diameter of 17 $\mu$m and average length of 180 $\mu$m) are blended by a shear melting process, and then the resin is dissolved out with a solvent; average diameter and average length of wollastonite are tested. It has been found that the diameter of wollastonite is kept the same and its average length changes about 0.5% during the shear process of the screw.

The toner is at least one or a mixture of more toners selected from the group consisting of a carbon black toner, a black toner, and an amorphous carbon toner. It is available to use color mixing via using black as the major color and adding a small amount of other colors of toners, such as, purple, blue, and red.

Preferably, the toner is selected from an amorphous carbon toner.

Preferably, the PA10T molding composite material has a 460 nm light source reflectivity of less than 5%, and more preferably, the P A10T molding composite material has a 460 nm light source reflectivity of less than 2.5-4%.

The PA10T molding composite material further includes 0-3 parts of an antioxidant in part by weight; the antioxidant is selected from at least one of from group consisting of hindered phenol antioxidants, hindered amine antioxidants, phosphite ester antioxidants, mercaptan antioxidants, and thiodipropionate antioxidants.

The PA10T molding composite material of the present invention is for use in preparing an LED display light source reflection support.

A method for preparing the PA10T molding composite material of the present invention includes the following steps: adding components to a blender mixer for uniform mixing, extruding and pelleting the mixed components with a twin-screw extruder to obtain the PA10T molding composite material, where the screw temperature ranges within 280-330°C, and the revolving speed is 450 r/min.

The present invention has the following beneficial effects:

The 460 nm light source reflectivity is mainly correlated to the surface roughness (when the surface roughness of an object becomes larger within a certain range, the ray of light emitted from a light source will generate diffuse reflection on the surface of the object, and finally, the energy of the ray of light received on a receiving end is less) and whiteness of materials (the lower the whiteness is, the lower the reflectivity is). The LED display light source reflection support mainly affects the gray scale and contrast of the LED display via whiteness and reflectivity of the light source reflection support. Based on the principle, the PA10T molding composite material of the present invention is to control the whiteness to be less than 26, and control the reflectivity of a 460 nm light source to be less than 6.5% (to improve the gray scale and contrast) through the following three aspects. Moreover, the PA10T molding composite material of the present invention has the advantages of low blue ray of the LED screen packaged with long-term packaging stability (tightness).

Firstly, compared with other inorganic fillers, wollastonite enables the surface roughness of the PA10T molding composite material workpiece to a reasonable range of reducing reflection of light, i.e., the reflectivity of a 460 nm light source is reduced. The preferable size distribution of the wollastonite in the resin matrix can further reduce the reflectivity of a 460 nm light source (to reduce the blue ray of the LED display).

Secondly, the color of materials is adjusted with a toner to obtain the black with good light absorption effect; preferably, the amorphous carbon toner can further reduce the whiteness and improve the light absorption, thereby reducing the reflectivity of a 460 nm light source.

Thirdly, through experimental findings, the crystallization peak width at half maximum of the PA10T molding composite material also will obviously affect the reflectivity of a 460 nm light source of the composite material; when the crystallization peak width at half maximum $\Delta T_{1/2}$ of the composite material is 3.5-10°C, the surface roughness of the prepared workpiece can meet the requirement of reducing the reflectivity of a 460 nm light source. In the technical solution of the present invention, the crystallization peak width at half maximum of the PA10T molding composite material is mainly adjusted by the amount and specification of the toner and wollastonite added, and the number average molecular weight of the PA10T.

Fourthly, on the other hand, the excellent tightness is achieved by adjusting the crystallization peak width at half maximum of the PA10T molding composite material, the specification of the wollastonite, and surface roughness.

The PA10T molding composite material of the present invention has no need for painting a light-absorbing paint or matting additionally, and thus reduces the cost of the LED display light source support.

## DETAILED DESCRIPTION OF EMBODIMENTS

The present invention will be further described with reference to the detailed examples. The following examples will help those skilled in that art further understand the present invention, but are not construed as limiting the scope of the present invention in any form. It should be indicated that those skilled in the art could further make several deformations and improvements in the premise of not departing from the inventive concept. These all fall within the protection scope of the present invention.

Raw materials used in the examples and comparative examples are as follows:

Monomers used in the polymerization of the following polyamides are commercially available products, polymerized pure.

PA10T-A: a number average molecular weight of 3,000 and a crystallization peak width at half maximum $\Delta T_{1/2}$ of 8.5°C, it is homemade referring to the method of the summary of the present invention;

PA10T-B: a number average molecular weight of 3400 and a crystallization peak width at half maximum $\Delta T_{1/2}$ of 5.6°C, it is homemade referring to the method of the summary of the present invention;

PA10T-C: a number average molecular weight of 5500 and a crystallization peak width at half maximum $\Delta T_{1/2}$ of 5.9°C, it is homemade referring to the method of the summary of the present invention;

PA10T-D: a number average molecular weight of 6500 and a crystallization peak width at half maximum $\Delta T_{1/2}$ of 6.5°C, it is homemade referring to the method of the summary of the present invention;

PA10T-E: a number average molecular weight of 10000 and a crystallization peak width at half maximum $\Delta T_{1/2}$ of

11.2°C, it is homemade referring to the method of the summary of the present invention;
PA10T-F: a number average molecular weight of 12000 and a crystallization peak width at half maximum $\Delta T_{1/2}$ of 12.4°C, it is homemade referring to the method of the summary of the present invention;
PA10T-G: a number average molecular weight of 25000 and a crystallization peak width at half maximum $\Delta T_{1/2}$ of 15.3°C, it is homemade referring to the method of the summary of the present invention.
Wollastonite A: an average diameter of 4 $\mu$m and an average length of 60 $\mu$m;
Wollastonite B: an average diameter of 6 $\mu$m and an average length of 120 $\mu$m;
Wollastonite C: an average diameter of 13 $\mu$m and an average length of 80 $\mu$m; and
Wollastonite D: an average diameter of 17 $\mu$m and an average length of 180 $\mu$m.

The wollastonite used in the present invention is purchased commercially and screened to obtain the required ranges of the average diameter and average length.

Talc powder: AH-1250, Guangxi Longsheng Huamei Talc Development Co., Ltd.
Toner A: amorphous carbon toner N774, Tianjin Tianyang Qiushi Chemical Technology Co. LTD.
Toner B: carbon black M570, CABOT Chemical;
Toner C: Black UN2014, CABOT Chemical;
Toner D: Mazcol Blue 153K, Shenzhen Dingtai Chemical Co., LTD.
Antioxidant: Irganox 1 098, hindered phenol antioxidants.

Methods for preparing the polyamide molding composite materials in examples and comparative examples: PA10T, wollastonite, toner and antioxidants were added to a blender mixer and mixed well, extruded and pelleted with a twin-screw extruder to obtain the PA10T molding composite material, where the screw temperature ranged within 280-330°C, and the revolving speed was 450 r/min.

Test method:

(1) Tightness: representation of the tightness of the support plastic and hardware by red ink testing on the PA10T molding composite material sample: a LED display light source support material and an electroplating hardware strip were soaked with red ink in an injection in-molded LED reflector cup; pins were soaked with red ink and placed to observe whether red ink permeates into the reflector cup.
If red ink does not permeate into the reflector cup within 5 min, the tightness grade was determined as level A;

if red ink does not permeate into the reflector cup within 3 min, but permeates within 5 min, the tightness grade was determined as level B;
if red ink does not permeate into the reflector cup within 1 min, but permeates within 3 min, the tightness grade was determined as level C;
if red ink permeates into the reflector cup within 1 min, the tightness grade was determined as level D; and
if the tightness grade was level D, the tightness between plastic and hardware was proved to be poor, which may lead to the risk of lamp bead failure. On the contrary, if the tightness grade was level A, B, or C, the packaged lamp bead has excellent gas tightness and good reliability.

(2) Whiteness: representation of the contrast of materials via its whiteness index: the PA10T molding composite material was injection molded to prepare a test piece having a length of 60 mm, a width of 60 mm, and a thickness of 1 mm. A Color Eye 7000A color difference meter was used to measure values L, a and b to calculate the whiteness:

$$W_H = 100 - [(100-L)^2 + a^2 + b^2]^{1/2}.$$

(3) Reflectivity: the PA10T molding composite material was injection molded to prepare a test piece having a length of 60 mm, a width of 60 mm, and a thickness of 1 mm. A Color Eye 7000A color difference meter was used to measure the reflectivity of the test piece to a 460 nm-wavelength light.
(4) Crystallization peak width at half maximum $\Delta T_{1/2}$ of the PA10T molding composite material: the PA10T molding composite material was heated up to 345°C from 30°C at a rate of 20°C/min under nitrogen conditions, 2 min later after constant temperature, cooled at a cooling rate of 20°C/min; the temperature of the crystallization peak emerging at this time was set as a crystallization temperature Tc (°C), and the temperature at an half of the peak width measured was set as a crystallization peak width at half maximum $\Delta T_{1/2}$.

Table 1: components (parts by weight) of the PA10T molding composite materials and test results in Examples 1-6

|  | Example 1 | Example 2 | Example 3 | Example 4 | Example 5 | Example 6 |
|---|---|---|---|---|---|---|
| PA10T-A | 60 | 60 | 60 | 60 | 60 | 60 |
| Wollastonite A | 30 | 35 | 40 | 45 | 50 | 60 |
| Toner A | 0.5 | 0.5 | 0.5 | 0.5 | 0.5 | 0.5 |
| Crystallization peak width at half maximum $\Delta T_{1/2}$, °C | 7.6 | 7.1 | 6.5 | 6.3 | 6.0 | 5.6 |
| Tightness grade | B | B | B | B | A | A |
| Whiteness | 25.88 | 25.61 | 25.17 | 24.35 | 23.80 | 24.22 |
| Reflectivity, % | 6.05 | 5.64 | 4.30 | 4.07 | 3.81 | 4.18 |

As can be seen from Examples 1-6, when the crystallization peak width at half maximum is controlled within the preferable range by increasing the amount of the wollastonite added, the tightness grade improves, whiteness and reflectivity are low.

Table 2: components (parts by weight) of the PA10T molding composite materials and test results in Examples 7-10

|  | Example 7 | Example 8 | Example 9 | Example 10 |
|---|---|---|---|---|
| PA10T-A | 60 | 60 | 60 | 60 |
| Wollastonite A | 45 | 45 | 45 | 45 |
| Toner A | 1 | 1.5 | 2 | 1 |
| Toner D |  |  |  | 0.5 |
| Crystallization peak width at half maximum $\Delta T_{1/2}$, °C | 6.3 | 6.3 | 6.3 | 6.3 |
| Tightness grade | B | B | B | B |
| Whiteness | 22.62 | 21.57 | 21.10 | 22.34 |
| Reflectivity, % | 3.24 | 2.88 | 2.64 | 3.04 |

As can be seen from Examples 4/7/8/9/10, whiteness and reflectivity are reduced by adjusting the amount of the toner used.

Table 3: components (parts by weight) of the PA10T molding composite materials and test results in Examples 11-15

|  | Example 11 | Example 12 | Example 13 | Example 14 | Example 15 |
|---|---|---|---|---|---|
| PA10T-A | 60 | 60 | 60 | 60 | 60 |
| Wollastonite A |  |  |  | 45 | 45 |
| Wollastonite B | 45 |  |  |  |  |
| Wollastonite C |  | 45 |  |  |  |
| Wollastonite D |  |  | 45 |  |  |
| Toner A | 0.5 | 0.5 | 0.5 |  |  |
| Toner B |  |  |  | 0.5 |  |
| Toner C |  |  |  |  | 0.5 |

(continued)

|  | Example 11 | Example 12 | Example 13 | Example 14 | Example 15 |
|---|---|---|---|---|---|
| Crystallization peak width at half maximum $\Delta T_{1/2}$, °C | 6.5 | 6.9 | 7.4 | 6.3 | 6.3 |
| Tightness grade | A | A | B | B | B |
| Whiteness | 24.18 | 23.94 | 24.64 | 24.70 | 25.53 |
| Reflectivity, % | 3.77 | 3.50 | 4.26 | 4.31 | 5.24 |

As can be seen from Examples 4/11-15, preferably, the wollastonite has an average diameter of 6-13 μm and an average length of 80-120 μm; the toner is preferably an amorphous carbon toner.

Table 4: components (parts by weight) of the PA10T molding composite materials and test results in Examples 16-21

|  | Example 16 | Example 17 | Example 18 | Example 19 | Example 20 | Example 21 |
|---|---|---|---|---|---|---|
| PA10T-B | 60 |  |  |  |  |  |
| PA10T-C |  | 60 |  |  |  |  |
| PA10T-D |  |  | 60 |  |  |  |
| PA10T-E |  |  |  | 60 |  |  |
| PA10T-F |  |  |  |  | 60 |  |
| PA10T-G |  |  |  |  |  | 60 |
| Wollastonite A | 45 | 45 | 45 | 45 | 45 | 45 |
| Toner A | 0.5 | 0.5 | 0.5 | 0.5 | 0.5 | 0.5 |
| Crystallization peak width at half maximum $\Delta T_{1/2}$, °C | 3.9 | 4.3 | 5.1 | 6.9 | 8.2 | 8.5 |
| Tightness grade | C | C | B | B | C | C |
| Whiteness | 23.64 | 24.30 | 23.55 | 24.15 | 24.81 | 24.53 |
| Reflectivity, % | 4.80 | 5.00 | 4.37 | 4.18 | 4.67 | 4.66 |

Table 5: components (parts by weight) of the PA10T molding composite materials and test results in Examples 22-24

|  | Example 22 | Example 23 | Example 24 | Example 25 | Example 26 |
|---|---|---|---|---|---|
| PA10T-B | 60 |  |  | 40 | 70 |
| PA10T-G |  | 60 | 60 |  |  |
| Wollastonite A | 35 | 55 |  | 35 | 60 |
| Wollastonite B |  |  | 55 |  |  |
| Toner A | 1.5 | 0.5 | 1 | 0.8 | 5 |
| Antioxidant |  |  | 0.5 |  |  |
| Crystallization peak width at half maximum $\Delta T_{1/2}$, °C | 4.5 | 7.0 | 6.9 | 4.1 | 4.2 |
| Tightness grade | B | B | A | B | B |
| Whiteness | 22.04 | 24.28 | 23.27 | 21.65 | 20.12 |

(continued)

| | Example 22 | Example 23 | Example 24 | Example 25 | Example 26 |
|---|---|---|---|---|---|
| Reflectivity, % | 3.01 | 3.96 | 3.46 | 2.88 | 2.25 |

As can be seen from Examples 4/16-24, the crystallization peak width at half maximum of the PA10T is adjusted by adding the wollastonite and toner, thus affecting the tightness grade, whiteness and reflectivity of the molding composite material. Specifically, as can be seen from Examples 16-21, when the crystallization peak width at half maximum in Examples 18/19 is within the preferable range, the tightness grade and reflectivity are better.

Table 6: components (parts by weight) of the PA10T molding composite materials and test results in Comparative Examples

| | Comparative Example 1 | Comparative Example 2 | Comparative Example 3 | Comparative Example 4 | Comparative Example 5 | Comparative Example 6 | Comparative Example 7 |
|---|---|---|---|---|---|---|---|
| PA10T-A | | | | 60 | 60 | 60 | 60 |
| PA10T-B | 60 | | | | | | |
| PA10T-G | | 60 | 60 | | | | |
| Wollastonite A | 70 | 20 | 70 | | 25 | 30 | 30 |
| Talc powder | | | | 45 | | | |
| Toner A | 0.5 | 0.5 | 0.5 | 0.5 | 0.5 | 0.2 | 6 |
| Crystallization peak width at half maximum $\Delta T_{1/2}$, °C | 2.9 | 10.4 | 8.3 | 6.5 | 7.1 | 7.6 | 7.2 |
| Tightness grade | D | D | D | D | C | B | D |
| Whiteness | 25.77 | 28.70 | 27.84 | 27.40 | 26.91 | 28.35 | 22.30 |
| Reflectivity, % | 7.20 | 7.88 | 7.35 | 12.33 | 6.80 | 7.21 | 6.8 |

As can be seen from Comparative Example 1, too high content of wollastonite will lead to a too low crystallization peak width at half maximum; the tightness grade is not only poor, but also the surface structure of the PA10T molding composite material workpiece is damaged, thus leading to poor reflectivity.

As can be seen from Comparative Example 2, too low content of wollastonite may not enable the crystallization peak width at half maximum to be reduced within 10°C; therefore, the tightness grade is not only poor, but also the reflectivity is high.

As can be seen from Comparative Example 3, the PA10T molding composite material added with too much wollastonite may not achieve the purposes of excellent tightness grade and low reflectivity even though the crystallization peak width at half maximum ranges from 3°C to 10°C. This is because too much wollastonite damages the surface structure of the composite material; moreover, as wollastonite is a kind of white powder, too much amount may increase the whiteness on the contrary.

As can be seen from Comparative Example 4, wollastonite may not be replaced by talc powder.

As can be seen from Comparative Example 5, if the content of wollastonite is too low, it fails to achieve the purposes of excellent tightness grade and low reflectivity even though the crystallization peak width at half maximum ranges from 3°C to 10°C.

As can be seen from Comparative Example 6, too low content of the toner may lead to a too high whiteness and a high reflectivity.

As can be seen from Comparative Example 7, too much toner added may lead to the enrichment of too much toner onto the surface, thereby affecting the tightness and reflectivity.

**Claims**

1. A PA10T molding composite material, **characterized by** comprising the following components in parts by weight:

   | | |
   |---|---|
   | PA10T resin | 40-70 parts; |
   | wollastonite | 30-60 parts; and |
   | toner | 0.4-5 parts; |

   in a resin matrix of the PA10T molding composite material, the wollastonite has an average diameter of 4 $\mu$m to 20 $\mu$m and an average length of 10 $\mu$m to 250 $\mu$m;
   a crystallization peak width at half maximum $\Delta T_{1/2}$ of the PA10T molding composite material is measured to be 3°C to 10°C by differential scanning calorimetry at a cooling rate of 20°C/min after being heated up to 345°C; and wherein the PA10T molding composite material has a whiteness of less than 26 and a 460 nm light source reflectivity of less than 6.5%.

2. The PA10T molding composite material according to claim 1, **characterized in that**, the crystallization peak width at half maximum $\Delta T_{1/2}$ of the PA10T molding composite material is measured to be 4.5°C to 7°C by differential scanning calorimetry at a cooling rate of 20°C/min after being heated up to 345°C.

3. The PA10T molding composite material according to claim 1, **characterized in that**, the PA10T resin has a number average molecular weight of 1,500 to 26,000.

4. The PA10T molding composite material according to claim 1, **characterized in that**, in the resin matrix of the PA10T molding composite material, the wollastonite has an average diameter of 6 $\mu$m to 13 $\mu$m and an average length of 80 $\mu$m to 120 $\mu$m.

5. The PA10T molding composite material according to claim 1, **characterized in that**, the toner is at least one or a mixture of more toners selected from the group consisting of a carbon black toner, a black toner, and an amorphous carbon toner.

6. The PA10T molding composite material according to claim 5, **characterized in that**, the toner is selected from an amorphous carbon toner.

7. The PA10T molding composite material according to claim 1, **characterized in that**, preferably, the PA10T molding composite material has a 460 nm light source reflectivity of less than 5%, and more preferably, the PA10T molding composite material has a 460 nm light source reflectivity of less than 2.5% to 4%.

**8.** The PA10T molding composite material according to claim 1, **characterized in that**, the PA10T molding composite material further comprises 0-3 parts of an antioxidant in part by weight.

**9.** A method for preparing the PA10T molding composite material according to any one of claims 1-8, **characterized by** comprising the following steps: adding components to a blender mixer for uniform mixing; extruding and pelleting the mixed components with a twin-screw extruder to obtain the PA10T molding composite material, wherein a screw temperature ranges within 280°C to 330°C, and a revolving speed ranges within 400 r/min to 500 r/min.

**10.** A use of the PA10T molding composite material according to any one of claims 1-8, in preparing an LED display light source reflection support.

## INTERNATIONAL SEARCH REPORT

International application No.

**PCT/CN2022/118968**

### A. CLASSIFICATION OF SUBJECT MATTER

C08L 77/06(2006.01)i; C08K 3/34(2006.01)i; C08K 3/04(2006.01)i; G09F 9/33(2006.01)i; G02B 1/04(2006.01)i

According to International Patent Classification (IPC) or to both national classification and IPC

### B. FIELDS SEARCHED

Minimum documentation searched (classification system followed by classification symbols)

C08L C08K G09F G02B

Documentation searched other than minimum documentation to the extent that such documents are included in the fields searched

Electronic data base consulted during the international search (name of data base and, where practicable, search terms used)

: WPABSC; CNTXT; ENTXT; WPABS; CJFD; DWPI; ENTXTC; CNKI; 百度学术, BAIDU SCHOLAR; 读秀, DUXIU, Web of Science; 珠海万通, 金发, 麦杰鸿, 蒋智强, 杨汇鑫, 黄险波, 姜苏俊, 阎昆, 李建伟, 徐显骏, PA, PA10T, 聚酰胺, 矽酸钙, 硅灰石, 黑种, 碳色粉, 炭黑, 碳黑, 色粉, 色母, 颜料, 色粒, 白度, 灰度, 黑度, 结晶峰, 半峰宽, 反射率, 半高宽, 对比度, Polyamide, Whiteness, Width at half maximum+, Grayscale, Crystallization peak, Contrast, Reflectivit+, Width at half height+, Width at half maximum, Whiteness+, wollastonite, pigment?, toner?, carbon black, Reflectivity, Width at half height.

### C. DOCUMENTS CONSIDERED TO BE RELEVANT

| Category* | Citation of document, with indication, where appropriate, of the relevant passages | Relevant to claim No. |
|---|---|---|
| PX | WO 2021204600 A1 (BASF SE et al.) 14 October 2021 (2021-10-14) description, paragraphs 11-19 and 36-94, and embodiments E1-E2, C1, and C7 | 1-10 |
| A | CN 103890039 A (SOLVAY SPECIALTY POLYMERS USA) 25 June 2014 (2014-06-25) description, paragraph 15, and embodiment E1 | 1-10 |
| A | CN 104804414 A (KINGFA SCIENCE AND TECHNOLOGY CO., LTD.) 29 July 2015 (2015-07-29) entire document | 1-10 |
| A | CN 105585841 A (EMS-PATENT AG) 18 May 2016 (2016-05-18) entire document | 1-10 |
| A | CN 103911000 A (CHEIL IND INC.) 09 July 2014 (2014-07-09) entire document | 1-10 |
| A | JP 2001131408 A (ASAHI KASEI CORP.) 15 May 2001 (2001-05-15) entire document | 1-10 |

☑ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **14 November 2022** | **29 November 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2022/118968** |

### C.    DOCUMENTS CONSIDERED TO BE RELEVANT

| Category* | Citation of document, with indication, where appropriate, of the relevant passages | Relevant to claim No. |
| --- | --- | --- |
| A | CN 106336659 A (JIANG MEN DE ZHONG TAI ENGINEERING PLASTICS TECHNOLOGY CO., LTD.) 18 January 2017 (2017-01-18) entire document | 1-10 |
| A | CN 1477153 A (KURARAY CO., LTD.) 25 February 2004 (2004-02-25) entire document | 1-10 |
| A | CN 112724667 A (KINGFA SCI. & TECH. CO., LTD. et al.) 30 April 2021 (2021-04-30) entire document | 1-10 |
| A | CN 112745672 A (KINGFA SCI. & TECH. CO., LTD. et al.) 04 May 2021 (2021-05-04) entire document | 1-10 |
| A | CN 107057344 A (KINGFA SCI. & TECH. CO., LTD. et al.) 18 August 2017 (2017-08-18) entire document | 1-10 |
| A | US 2003036625 A1 (E. I. DU PONT DE NEMOURS AND COMPANY) 20 February 2003 (2003-02-20) entire document | 1-10 |
| A | JP 2015074763 A (PANASONIC IP MAN CORP.) 20 April 2015 (2015-04-20) entire document | 1-10 |
| A | CN 108383996 A (KINGFA SCI. & TECH. CO., LTD. et al.) 10 August 2018 (2018-08-10) entire document | 1-10 |

Form PCT/ISA/210 (second sheet) (January 2015)

### INTERNATIONAL SEARCH REPORT
#### Information on patent family members

International application No.

**PCT/CN2022/118968**

| Patent document cited in search report | | | Publication date (day/month/year) | Patent family member(s) | | | Publication date (day/month/year) |
|---|---|---|---|---|---|---|---|
| WO | 2021204600 | A1 | 14 October 2021 | TW | 202144495 | A | 01 December 2021 |
| CN | 103890039 | A | 25 June 2014 | EP | 2744846 | A1 | 25 June 2014 |
| | | | | KR | 20140058635 | A | 14 May 2014 |
| | | | | US | 2014221546 | A1 | 07 August 2014 |
| | | | | JP | 2014521822 | A | 28 August 2014 |
| | | | | WO | 2013026780 | A1 | 28 February 2013 |
| CN | 104804414 | A | 29 July 2015 | CN | 104804414 | B | 16 February 2018 |
| CN | 105585841 | A | 18 May 2016 | KR | 20160056301 | A | 19 May 2016 |
| | | | | EP | 3020746 | A1 | 18 May 2016 |
| | | | | BR | 102015028401 | A2 | 27 September 2016 |
| | | | | CN | 114350147 | A | 15 April 2022 |
| | | | | MX | 2015015608 | A | 15 July 2016 |
| | | | | JP | 2016094601 | A | 26 May 2016 |
| | | | | US | 2016130439 | A1 | 12 May 2016 |
| | | | | US | 10233326 | B2 | 19 March 2019 |
| | | | | EP | 3020746 | B1 | 26 August 2020 |
| | | | | JP | 6782069 | B2 | 11 November 2020 |
| | | | | KR | 102396033 | B1 | 10 May 2022 |
| CN | 103911000 | A | 09 July 2014 | DE | 102013226703 | A1 | 03 July 2014 |
| | | | | KR | 20140087663 | A | 09 July 2014 |
| | | | | US | 2014187662 | A1 | 03 July 2014 |
| | | | | CN | 103911000 | B | 30 November 2016 |
| | | | | US | 9018296 | B2 | 28 April 2015 |
| | | | | DE | 102013226703 | B4 | 21 January 2021 |
| | | | | KR | 101566063 | B1 | 04 November 2015 |
| JP | 2001131408 | A | 15 May 2001 | JP | 2001131408 | A5 | 15 May 2001 |
| CN | 106336659 | A | 18 January 2017 | | None | | |
| CN | 1477153 | A | 25 February 2004 | US | 2004034152 | A1 | 19 February 2004 |
| | | | | TW | 200401803 | A | 01 February 2004 |
| | | | | KR | 20040000326 | A | 03 January 2004 |
| | | | | CA | 2432522 | A1 | 21 December 2003 |
| | | | | EP | 1375578 | A1 | 02 January 2004 |
| | | | | SG | 111114 | A1 | 30 May 2005 |
| | | | | JP | 2004075994 | A | 11 March 2004 |
| | | | | CN | 1260300 | C | 21 June 2006 |
| | | | | US | 7009029 | B2 | 07 March 2006 |
| | | | | TW | I258494 | B | 21 July 2006 |
| | | | | SG | 111114 | B | 29 September 2006 |
| | | | | KR | 926927 | B1 | 17 November 2009 |
| | | | | CA | 2432522 | C | 21 September 2010 |
| CN | 112724667 | A | 30 April 2021 | CN | 112724667 | B | 14 June 2022 |
| | | | | WO | 2022127248 | A1 | 23 June 2022 |
| CN | 112745672 | A | 04 May 2021 | CN | 112745672 | B | 14 June 2022 |
| | | | | WO | 2022127249 | A1 | 23 June 2022 |
| CN | 107057344 | A | 18 August 2017 | WO | 2018133294 | A1 | 26 July 2018 |
| US | 2003036625 | A1 | 20 February 2003 | WO | 0109233 | A1 | 08 February 2001 |
| | | | | ES | 2215058 | T3 | 01 October 2004 |
| | | | | CA | 2378941 | A1 | 08 February 2001 |
| | | | | EP | 1200516 | A1 | 02 May 2002 |

Form PCT/ISA/210 (patent family annex) (January 2015)

**INTERNATIONAL SEARCH REPORT**
Information on patent family members

International application No.

**PCT/CN2022/118968**

| Patent document cited in search report | | | Publication date (day/month/year) | Patent family member(s) | | | Publication date (day/month/year) |
|---|---|---|---|---|---|---|---|
| | | | | DK | 1200516 | T3 | 26 April 2004 |
| | | | | DE | 60008879 | D1 | 15 April 2004 |
| | | | | AT | 261469 | T | 15 March 2004 |
| | | | | AU | 6511700 | A | 19 February 2001 |
| | | | | PT | 1200516 | E | 31 May 2004 |
| | | | | EP | 1200516 | B1 | 10 March 2004 |
| | | | | JP | 2001106908 | A | 17 April 2001 |
| | | | | US | 6784279 | B2 | 31 August 2004 |
| JP | 2015074763 | A | 20 April 2015 | JP | 6241724 | B2 | 06 December 2017 |
| CN | 108383996 | A | 10 August 2018 | WO | 2019137303 | A1 | 18 July 2019 |
| | | | | CN | 108383996 | B | 30 October 2020 |

Form PCT/ISA/210 (patent family annex) (January 2015)